(19) Europäisches Patentamt

European Patent Office

Office européen des brevets

(11) **EP 4 528 525 A1**

(12) **EUROPEAN PATENT APPLICATION**

(43) Date of publication:
**26.03.2025 Bulletin 2025/13**

(21) Application number: **24201652.5**

(22) Date of filing: **20.09.2024**

(51) International Patent Classification (IPC):
**G06F 15/80** (2006.01)        **G06F 30/30** (2020.01)
**G06F 9/30** (2018.01)

(52) Cooperative Patent Classification (CPC):
**G06F 30/30; G06F 9/3001; G06F 15/80**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.09.2023   US 202363584353 P
11.09.2024   US 202418882342**

(71) Applicant: **Groq, Inc.
Mountain View, CA 94041 (US)**

(72) Inventors:
• **Candler, Frederick Christopher
94041 Mountain View (US)**
• **Dai, Zefu
94041 Mountain View (US)**

(74) Representative: **Epping - Hermann - Fischer
Patentanwaltsgesellschaft mbH
Schloßschmidstraße 5
80639 München (DE)**

(54) **BALANCED BINARY TREE STRUCTURES FOR STREAM REDUCING OPERATIONS**

(57)    Methods, systems, and other embodiments are described for incorporating a balanced binary tree into the multiplication modules of a tensor processor to execute sequences of instructions more efficiently for Stream Reducing operations. This Abstract and the independent Claims are concise signifiers of embodiments of the claimed inventions. The Abstract does not limit the scope of the claimed inventions.

FIGURE 1

100

**Description**

**CROSS-REFERENCE TO RELATED APPLICATIONS**

This application claims the benefit of priority to United States Provisional Application Number 63/584,353, filed September 21, 2023, and entitled "BALANCED BINARY TREE STRUCTURES FOR STREAM REDUCING OPERATIONS," the entirety of which is expressly incorporated herein by reference.

**COPYRIGHT NOTICE**

*This patent document can be exactly reproduced as it appears in the files of the United States Patent and Trademark Office, but the assignee(s) otherwise reserves all rights in any subsets of included original works of authorship in this document protected by 17 USC 102(a) of the U.S. copyright law.*

**SPECIFICATION** - **DISCLAIMERS**

*In the following Background, Summary, and Detailed Description, paragraph headings are signifiers that do not limit the scope of an embodiment of a claimed invention (ECIN). The citation or identification of any publication signifies neither relevance nor use as prior art. A paragraph for which the font is all italicized signifies text that exists in one or more patent specifications filed by the assignee(s).*

*A writing enclosed in double quotes ("") signifies an exact copy of a writing that has been expressed as a work of authorship. Signifiers, such as a word or a phrase enclosed in single quotes (''), signify a term that as of yet has not been defined and that has no meaning to be evaluated for, or has no meaning in that specific use (for example, when the quoted term 'module' is first used) until defined*

**FIELD(S) OF TECHNOLOGY**

This disclosure has general significance in the field of architectures for high-performance processors, and in particular, significance for the following topics: advantageous interconnection of functional blocks in high-performance processors. This information is limited to use in the searching of the prior art.

**BACKGROUND**

A tensor is a family of mathematical structures that includes vectors, matrices, and higher dimensional arrays. Tensors are used in many fields of science and engineering, and huge tensors with millions to billions of elements are used in numerical calculations, such as machine learning. One operation - multiplication - requires huge amounts of processing power for large tensors, for which specialized processors have been developed in recent years.

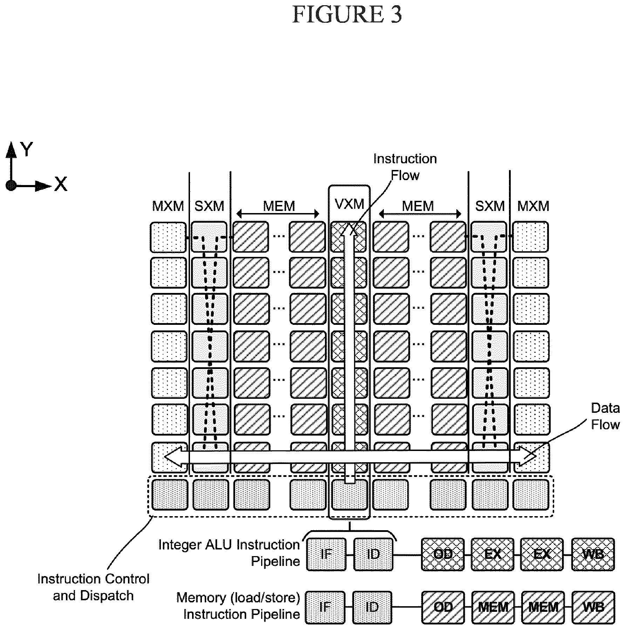

One type of a tensor processor is deterministic (the time and location of all instruction executions known before execution); for example, the tensor streaming processors (TSPs) sold by Groq Incorporated. These types of deterministic processors comprise a two-dimensional mesh of processor cores, where data flows across lanes and instructions flow across slices. This is generally depicted in Figure 3.

In this organization of a tensor processor, each computational element implements a specific function and is stacked vertically into a specific "functional slice" in one dimension (e.g., the Y-dimension) of the two-dimensional on-chip mesh. Each functional slice is independently controlled by a sequence of instructions specific to its on-chip role. For instance, the MEM (memory) functional slices support Read and Write but not, necessarily Add (addition) or Mul (multiply), which are typically performed in arithmetic functional slices (e.g., the vector execution module (VXM) and matrix execution module (MXM) functional slices) for some typical machine learning (ML) algorithms, such as the linear regression algorithm. In the X dimension, each functional row comprises a full set of different types of functional cores, e.g., MEM, VXM, MXM, SXM (switching and permutation module), etc. Each functional row is referred to herein as a *superlane.*

In the TSP architecture, data flows in the X dimension, and instructions flow in the Y dimension. The functional slices operate on the data streams in a Single Instruction Multiple Data (SIMD) manner, where different data streams are processed independently at different superlanes of the same functional slice using the same instruction sequence. Physically, it takes time for an instruction to travel from one superlane to the next. As a result, the data streams in different superlanes need to arrive at a functional slice with a staggering delay. For example, with a staggering delay of 1 clock cycle, the data streams will arrive at superlane 0 at time t, and superlane 1 at time t+1, so on and so forth. If the staggering delay is 2, then data streams arrive at superlane 0 at time t, superlane 1 at time t+2, superlane 2 at time t+4, so on and so forth.

The data stream staggering delay is dictated by the requirement to arrive in time for its intended instructions to execute correctly at each functional slice. On the other hand, the data stream staggering delay is determined by the traversing delay of the instruction sequence that produces the data stream. For example, a sequence of memory read instructions traversing through a MEM slice, with a 1 clock cycle delay going from one superlane to the next, will produce data streams with a staggering delay of 1 clock cycle. Naturally, for different functional slices to be compatible with each other, the staggering delay needs to be the same.

In conventional Machine Learning (ML) and High Performance Computing (HPC) applications, there are special operations that perform aggregation on multiple data streams and produce fewer streams or a single result stream. We call such operations that consume multiple input streams and produce fewer output streams *Stream Reducing* operations. Different from typical SIMD operations, where each functional core operates on x input streams and produces x output streams in the same dimension (dimension X), the stream reducing operations need to change the direction of data flow from X dimension to Y dimension for aggregation, then from Y dimension back to X dimension for writing back of a single result stream.

For example, in matrix multiplication $C = A \cdot B$, an element $c_{ij}$ in the result matrix C is the sum of s multiplications between elements of the i-th row of matrix A and the j-th column of matrix B, for example,

$$c_{ij} = \sum_{x=0}^{n} \left( a_{ix} \times b_{xj} \right)$$

, where s is the number of columns in matrix A or the number of rows in matrix B. To compute a matrix multiplication on a TSP, the operation $(a_{ix} \times b_{xj})$ is carried out in parallel in six different superlanes, where each superlane processes x element multiplications. Each result element, $c_{ij}$, is calculated by aggregation of multiplication results from six superlanes, and then written back to a single result stream that resides in the i/x superlane.

Stream reducing operations are indispensable for both ML and HPC applications. Due to their differences with typical SIMD operations, others have failed to implement these operations efficiently in deterministic streaming processors, and thus are unable to provide solutions to at least the following three problems:

1) Fully managing the dependency between the completion time of operations in X and Y dimensions. The stream reducing operation at each superlane requires the input streams from the X and Y dimensions to synchronize with each other. This requires efficiently staggering the input data stream with a delay determined by the partial aggregation logic at each superlane in addition to the instruction traversal time through the superlanes.

2) Different stream reducing operations can incur different delays determined by the aggregation logic required, which in turn determines the staggering delay of the data streams. As a result, it adds additional challenges to support multiple stream reducing operations at the architectural level in a unified manner.

3) Stream reducing increases the wiring demand on the slices over which instructions flow. This is due to the need to pass partial aggregation results from one superlane to its adjacent superlanes. In addition, the final result of stream reducing operations needs to be written back to a target superlane based on the index.

What others have failed to provide are methods to more efficiently generate sequences of instructions to optimize stream reducing for tensor processors.

## SUMMARY

*This Summary, together with any Claims, is a briefset ofsignifiers for at least one ECIN (which can be a discovery, see 35 USC 100(a); and see 35 USC 100(j)), for use in commerce for which the Specification and Drawings satisfy 35 USC 112.*

In one or more ECINs disclosed herein, balanced binary tree structures are disclosed and are incorporated into the multiplication modules of tensor processors, to address the previously unsolved problems of efficiently executing instructions for stream reducing operations. Specifically, balanced binary tree structures are disclosed that can advantageously be used to cancel out delay dependency in aggregation logic, eliminating the requirement to further stagger the data streams according to the aggregation delay. As a result, different stream reducing operations can be unified.

In one or more ECINs disclosed herein, balanced binary tree structures are disclosed that enable the compiler to locally optimize the aggregation operation for timing/area as needed without having an impact on the overall architecture.

In one or more ECINs disclosed herein, a balanced binary tree structure is enabled with identical unit logic design for all superlanes, which allows for more efficient design scalability of TSPs.

*This Summary does not completely signify any ECIN. While this Summary can signify at least one essential element of an ECIN enabled by the Specification and Figures, the Summary does not signify any limitation in the scope of any ECIN.*

## DRAWINGS

*The following Detailed Description, Figures, and Claims signify the uses of and progress enabled by one or more ECINs. All of the Figures are used only to provide knowledge and understanding and do not limit the scope of any ECIN. Such Figures are not necessarily drawn to scale.*

*The Figures can have the same, or similar, reference signifiers in the form of labels (such as alphanumeric symbols, e.g., reference numerals), and can signify a similar or equivalent function or use. Further, reference signifiers of the same type can be distinguished by appending to the reference label a dash and a second label that distinguishes among the similar signifiers. If only the first label is used in the Specification, its use applies to any similar component having the same label irrespective of any other reference labels. A brief list of the Figures is below.*

Figure 1 depicts a system for compiling programs to be executed on a tensor processor according to an embodiment.

Figures 2A and 2B illustrate instruction and data flow in a processor having a functional slice architecture, in accordance with some embodiments.

Figure 3 illustrates instruction and data flow in a processor having a functional slice architecture according to some embodiments.

Figure 4 illustrates an MXM slice and a daisy chain circuit incorporated into the MXM slice according to some embodiments.

Figure 5 illustrates an MXM slice and a balanced binary tree circuit incorporated into the MXM slice according to some embodiments.

Figure 6 illustrates one unit of the balanced binary tree circuit according to some embodiments.

Figure 7 illustrates an unbalanced binary tree circuit according to some embodiments.

Figures 8A-8C illustrate a balanced binary tree comprising 4 superlanes according to some embodiments.

Figure 9 illustrates a balanced binary tree comprising 8 superlanes according to some embodiments.

Figure 10 illustrates a balanced binary tree comprising 16 superlanes according to some embodiments.

Figure 11 illustrates a computer system suitable for enabling embodiments of the claimed inventions.

*In the Figures, reference signs can be omitted as is consistent with accepted engineering practice; however, a skilled person will understand that the illustrated components are understood in the context of the Figures as a whole, of the accompanying writings about such Figures, and of the embodiments of the claimed inventions.*

## DETAILED DESCRIPTION

*The Figures and Detailed Description, only to provide knowledge and understanding, signify at least one ECIN. To minimize the length of the Detailed Description, while various features, structures or characteristics can be described together in a single embodiment, they also can be used in other embodiments without being written about. Variations of any of these elements, and modules, processes, machines, systems, manufactures, or compositions disclosed by such embodiments and/or examples are easily used in commerce. The Figures and Detailed Description signify, implicitly or explicitly, advantages and improvements of at least one ECIN for use in commerce.*

*In the Figures and Detailed Description, numerous specific details can be described to enable at least one ECIN. Any embodiment disclosed herein signifies a tangible form of a claimed invention. To not diminish the significance of the embodiments and/or examples in this Detailed Description, some elements that are known to a skilled person can be combined for presentation and for illustration purposes and not be specified in detail. To not diminish the significance of these embodiments and/or examples, some well-known processes, machines, systems, manufacture, or compositions are not written about in detail. However, a skilled person can use these embodiments and/or examples in commerce without these specific details or their equivalents. Thus, the Detailed*

*Description focuses on enabling the inventive elements of any ECIN. Where this Detailed Description refers to some elements in the singular tense, more than one element can be depicted in the Figures and like elements are labeled with like numerals.*

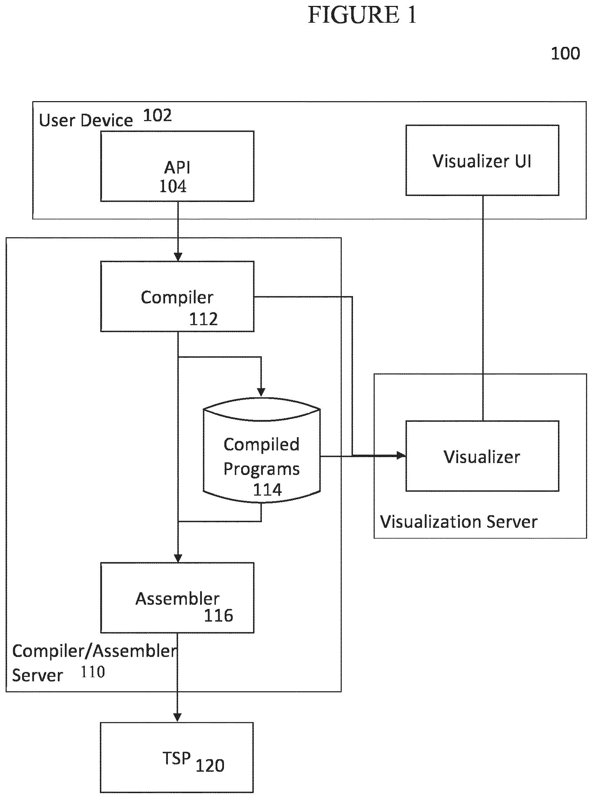

Figure 1 illustrates a system 100 for compiling programs to be executed on a tensor processor according to an embodiment. The system can also be utilized to generate power usage information for compiled programs according to some embodiments. The system 100 includes a user device 102, a server 110, and a processor 120. Each of these components, and their sub-components (if any) are described in greater detail below. Although a particular configuration of components is described herein, in other embodiments the system 100 have different components and these components perform the functions of the system 100 in a different order or using a different mechanism. For example, while Figure 1 illustrates a single server 110, in other embodiments, compilation, assembly, and power usage functions are performed on different devices. For example, in some embodiments, at least a portion of the functions performed by the server 110 are performed by the user device 102.

The user device 102 comprises any electronic computing device, such as a personal computer, laptop, or workstation, which uses an Application Program Interface (API) 104 to construct programs to be run on the processor 120. The server 110 receives a program specified by the user at the user device 102 and compiles the program to generate a compiled program 114. In some embodiments, a compiled program 114 enables a data model for predictions that processes input data and makes a prediction from the input data. Examples of predictions are category classifications made with a classifier, or predictions of time series values. In some embodiments, the prediction model describes a machine learning model that includes nodes, tensors, and weights. In one embodiment, the prediction model is specified as a TensorFlow model, a compiler 112 is a TensorFlow compiler and the processor 120 is a tensor processor. In another embodiment, the prediction model is specified as a PyTorch model, the compiler is a PyTorch compiler. In other embodiments, other machine learning specification languages and compilers are used. For example, in some embodiments, the prediction model defines nodes representing operators (e.g., arithmetic operators, matrix transformation operators, Boolean operators, etc.), tensors representing operands (e.g., values that the operators modify, such as scalar values, vector values, and matrix values, which may be represented in integer or floating-point format), and weight values that are generated and stored in the model after training. In some embodiments, where the processor 120 is a tensor processor having a functional slice architecture, the compiler 112 generates an explicit plan for how the processor will execute the program, by translating the program into a set of operations that are executed by the processor 120, specifying when each instruction will be executed, which functional slices will perform the work, and which stream registers will hold the operands. This type of scheduling is known as "deterministic scheduling." This explicit plan for execution includes information for explicit stream reduction processing by means of a balanced binary tree architecture.

An assembler 116 receives compiled programs 114, generated by the compiler 112, and performs final compilation and linking of the scheduled instructions to generate a compiled binary. In some embodiments, the assembler 116 maps the scheduled instructions indicated in the compiled program 114 to the hardware of the server 110, and then determines the exact component queue in which to place each instruction.

The processor 120, for example, is a hardware device with a massive number of matrix multiplier units that accepts a compiled set of instruction bits, (e.g., a "binary") assembled by the assembler 116, and executes the instructions included in the compiled binary. The processor 120 can include one or more blocks of circuity for matrix arithmetic, numerical conversion, vector computation, short-term memory, and data permutation/switching. Once such processor 120 is a tensor processor having a functional slice architecture. In some embodiments, the processor 120 comprises multiple tensor processors connected together to function as a single deterministic component.

EXAMPLE PROCESSOR

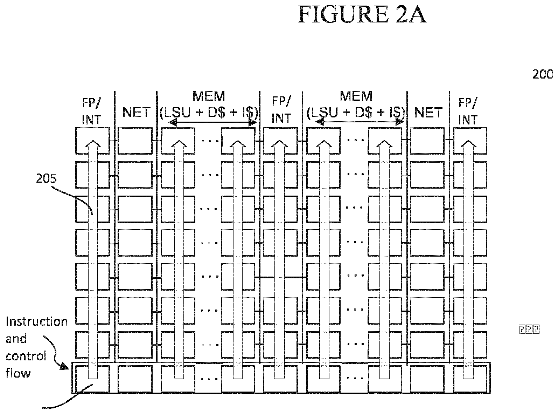

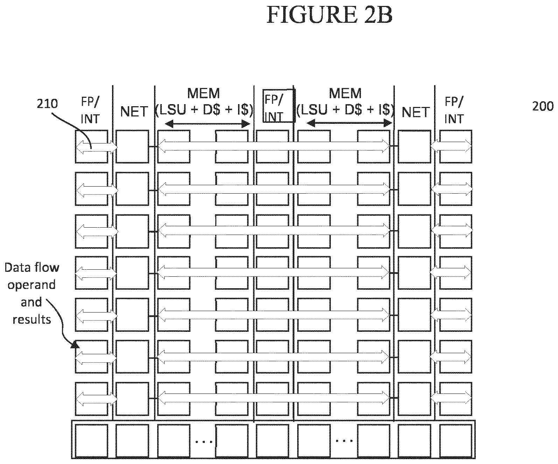

Figures 2A and 2B illustrate instruction and data flow in a processor having a functional slice architecture, in accordance with some embodiments. One enablement of processor 200 is as an application specific integrated circuit (ASIC) and corresponds to processor 120 illustrated in Figure 1.

The functional units of processor 200 (also referred to as "functional tiles") are aggregated into a plurality of functional process units (hereafter referred to as "slices") 205, each corresponding to a particular function type in some embodiments. For example, different functional slices of the processor correspond to processing units for MEM (memory), VXM (vector execution module), MXM (matrix execution module), NIM (numerical interpretation module), and SXM (switching and permutation module). In other embodiments, each tile may include an aggregation of functional units such as a tile having both MEM and execution units by way of example. As illustrated in Figures 2A and 2B, each slice corresponds to a column of $N$ functional units extending in a direction different (e.g., orthogonal) to the direction of the flow of data. The functional units of each slice can share an instruction queue (not shown) that stores instructions, and an instruction control unit (ICU) 210 that controls execution flow of the instructions. The instructions in each instruction queue are executed only by functional units in the queue's associated slice and are not executed by another slice of the processor. In other embodiments, each functional unit has an associated ICU that controls the execution flow of the instructions.

Processor 200 also includes communication lanes to carry data between the functional units of different slices. Each communication lane connects to each of the slices 205 of processor 200. In some embodiments, a communication lane 220 that connects a row of functional units of adjacent slices is referred to as a "super-lane", and comprises multiple data lanes, or "streams", each configured to transport data values along a particular direction. For example, in some embodiments, each functional unit of processor 200 is connected to corresponding functional units on adjacent slices by a super-lane made up of multiple lanes. In other embodiments, processor 200 includes communication devices, such as a router, to carry data between adjacent functional units.

By arranging the functional units of processor 200 into different functional slices 205, the on-chip instruction and control flow of processor 200 is decoupled from the data flow. Since many types of data are acted upon by the same set of instructions, what is important for visualization is visualizing the flow of instructions, not the flow of data. For some embodiments, Figure 2A illustrates the flow of instructions within the processor architecture, while Figure 2B illustrates the flow of data within the processor architecture. As illustrated in Figures 2A and 2B, the instructions and control signals flow in a first direction across the functional units of processor 200 (e.g., along the length of the functional slices 205), while the data flows flow in a second direction across the functional units of processor 200 (e.g., across the functional slices) that is non-parallel to the first direction, via the communication lanes (e.g., super-lanes) connecting the slices.

In some embodiments, the functional units in the same slice execute instructions in a 'staggered' fashion where instructions are issued tile-by-tile within the slice over a period of N cycles. For example, the ICU for a given slice may, during a first clock cycle, issues an instruction to a first tile of the slice (e.g., the bottom tile of the slice as illustrated in Figure 2B, closest to the ICU of the slice), which is passed to subsequent functional units of the slice over subsequent cycles. That is, each row of functional units (corresponding to functional units along a particular super-lane) of processor 200 executes the same set of instructions, albeit offset in time, relative to the functional units of an adjacent row.

The functional slices of the processor are arranged such that operand data read from a memory slice is intercepted by different functional slices as the data moves across the chip, and results flow in the opposite direction where they are then written back to memory. For example, a first data flow from a first memory slice flows in a first direction (e.g., towards the right), where it is intercepted by a VXM slice that performs a vector operation on the received data. The data flow then continues to an MXM slice which performs a matrix operation on the received data. The processed data then flows in a second direction opposite from the first direction (e.g., towards the left), where it is again intercepted by VXM slice to perform an accumulate operation, and then written back to the memory slice.

In some embodiments, the functional slices of the processor are arranged such that data flow between memory and functional slices occur in both the first and second directions. For example, a second data flow originating from a second memory slice that travels in the second direction towards a second slice, where the data is intercepted and processed by VXM slice before traveling to the second MXM slice. The results of the matrix operation performed by the second MXM slice then flow in the first direction back towards the second memory slice.

In some embodiments, stream registers are located along a super-lane of the processor, in accordance with some embodiments. The stream registers are located between functional slices of the processor to facilitate the transport of data (e.g., operands and results) along each super-lane. For example, within the memory region of the processor, stream registers are located between sets of four MEM units. The stream registers are architecturally visible to the compiler and serve as the primary hardware structure through which the compiler has visibility into the program's execution. Each functional unit of the set contains stream circuitry that is configured to allow the functional unit to read or write to the stream registers in either direction of the super-lane. In some embodiments, each stream register is implemented as a collection of registers, corresponding to each stream of the super-lane, and sized based upon the basic data type used by the processor (e.g., if the TSP's basic data type is an INT8, each register may be 8-bits wide). In some embodiments, to support larger operands (e.g., FP16 or INT32), multiple registers are collectively treated as one operand, where the operand is transmitted over multiple streams of the super-lane.

All of these functional features - superlanes of functional units, slices of instruction flow, handling of different types of integers and floating-point numbers, occurring trillions of times a second, create complicated power flows and possible disruptive power fluctuations that could negatively impact the performance of the processor. However, given the deterministic nature of executions by the processor, any disruptive power fluctuations (such as voltage droop) can be determined before execution of the program, with information (such as processor instructions, and timing for such instructions) about such fluctuations being supplied by the compiler to the processor, for the processor to use during program execution to mitigate the fluctuations.

STREAM REDUCTION

A stream reducing instruction can be considered as having two sub-operations ("sub-ops"): distributed Y dimension aggregation and Y dimension result write-back. The distributed Y dimension aggregation performs partial aggregation at each superlane. This sub-op has timing dependency on both the X and Y dimension inputs, meaning the operands from X and Y dimensions need to be correctly related to each other to produce correct partial aggregation results. The Y dimension result write-back writes the final aggregation result back to a target superlane through a dedicated bus in the Y dimension that reaches all superlanes.

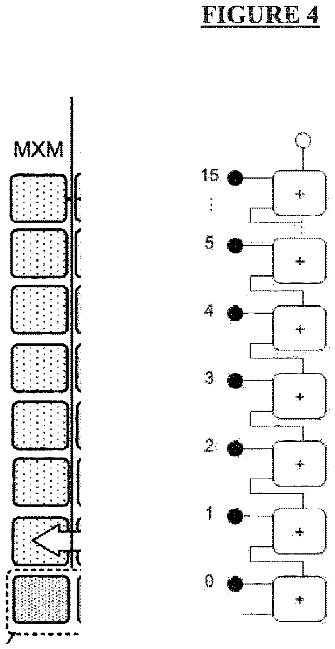

As described above, the key challenges of stream reducing operations arise from the aggregation in the Y dimension. A naive implementation would daisy chain the n superlanes from 0 to n-1 in order. An example of a daisy chain incorporated into an MXM slice is depicted in Figure 4. The advantages of such implementation include: 1) The partial aggregation logic at superlane $i$ only needs to look at superlane $i$ and ($i-1$) for input operands, the logic is agnostic to the superlane number/-ID, thus only needs to be implemented once and duplicated for all superlanes; and 2) The output of the partial aggregation logic only needs to be routed to the next superlane. There is no need for the partial result to go across multiple superlanes. This reduces the routing resource requirement on the Y dimension.

The disadvantages, however, have a more significant impact on the TSP architecture: 1) The delay of the partial aggregation logic must match the data stream staggering delay $d$. So either the partial aggregation logic has to complete within delay of $d$, or the staggering delay of the data streams, as well as the instruction propagation path of the functional slices, need to be adjusted according to the requirement of each stream reducing instruction, which could become costly for the entire TSP chip; and 2) the input data needs to go through a longer chain of aggregation logic, which could lead to precision loss. For example, the input from superlane 0 needs to go through an entire chain of n partial aggregation logic elements.

BALANCED BINARY TREE

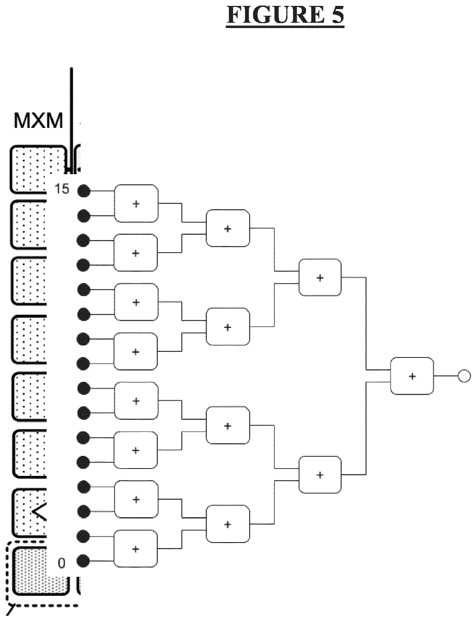

Figure 5 illustrates an MXM slice and a balanced binary tree circuit incorporated into the MXM slice, for 16 superlanes. In the daisy chain structure, the arrival time of the operand in superlane 1 needs to match the partial aggregation output from superlane 0, which is determined by the delay of the partial aggregation logic $d$. In other words, the operand in superlane $i$ needs to arrive at time $i*d$. Since delay $d$ is involved in determining the operand arrival time, it means the architecture has a dependency on the partial aggregation logic implementation, e.g., when the implementation of the partial aggregation logic changes, the other part of the design also needs to change. Or if the architecture remains the same, the partial aggregation logic needs to meet the delay constraint imposed by the data stream staggering delay.

In contrast, the delay of the partial aggregation logic is canceled out in the balanced binary tree structure.

For 16 superlanes, there are 4 layers of partial aggregation logic from the leaf nodes to the root node, where the root node produces the final aggregation result. In the first layer close to the leaf nodes, the arrival time of the operands has no dependency on the aggregation logic. Assuming the data arrives with a 1-cycle staggering delay, e.g., data in superlane $i$ arrives in cycle $i$, the partial aggregation logic in the first layer only needs to insert a 1-cycle delay for the operand coming from the lower superlane. In the second layer, the arrival time of the two operands is $2*j+1+d$ and $2*j+3+d$ respectively for the $j$-th partial aggregation logic in the second layer. Therefore, the aggregation logic only needs to insert a 2-cycle delay for the lower operand. Note that the delay of the partial aggregation logic $d$ from the previous layer is canceled out between the two operands feeding into the same partial aggregation logic and the number of delay buffers required is purely determined by the initial data stream staggering delay. This continues as operands are processed by the balanced binary tree structure, and the partial aggregation logic needs to insert a 4-cycle delay for its lower operand in the third layer and a 8-cycle delay in the fourth layer.

The delay from layer to layer is the accumulation of the delay from the previous layer plus the current layer. Thus, delay buffering added at each layer does not increase as data moves further down in the layers. Additionally, the delay at each layer in the binary tree is the same since it is a balanced binary tree.

The advantages of the balanced binary tree structure are as follows. The delay of the partial aggregation logic does not impact other parts of the design or dictate the data stream staggering delay. In other words, there are fewer constraints on how the aggregation logic should be implemented. Multiple stream reduction instructions can be supported without significant impact to the overall architecture or the data staggering delay. The data traverses fewer stages of partial aggregation to reach the final result, which could lead to better precision. It requires less partial aggregation logic than the daisy chained structure when the number of superlanes is larger than two.

The disadvantages are: It becomes difficult to partition the balanced binary tree into different superlanes and make them identical. For TSPs, it is critical to keep all superlanes identical to reduce both logical and physical design cost. The output of a partial aggregation logic may need to be routed to a non-adjacent superlane depending on its location in the binary tree. This increases the routing traffic between different superlanes. The number of superlanes preferably is a power of two, otherwise the delay of the partial aggregation logic cannot be entirely canceled out. If the number of superlanes is not a power of 2, the required additional buffering capacity grows by log2 as a function of the depth of the tree.

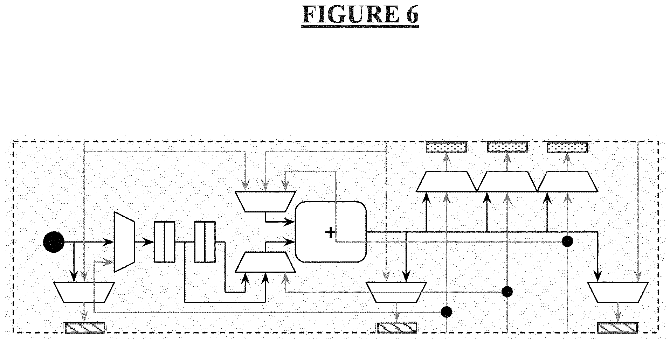

Figure 6 illustrates one unit of the balanced binary tree circuit, which is identically incorporated into each superlane. In this configurable logic unit design, a set of multiplexers are added at each position where the design may vary depending on the location of the superlane. The varied design can use a different signal routing, or different delay paths. The selection signals of those multiplexers are controlled by a group of configuration registers, which are set by software at initialization time.

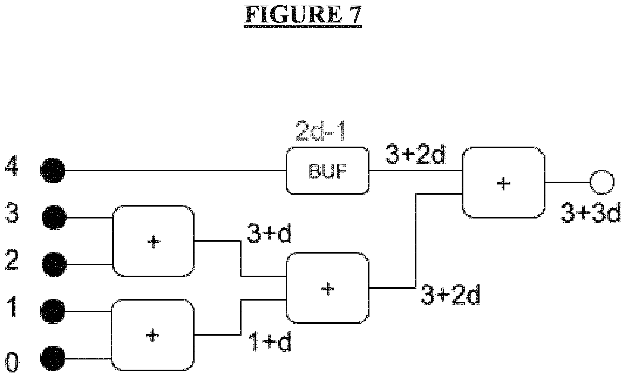

Figure 7 illustrates an unbalanced binary tree circuit using 5 superlanes as an example. While aggregation of superlanes 0-3 is balanced nicely, the aggregation of superlane 4 and the partial result from 0-3 is not balanced in terms of branch depth or delay. As a result, superlane 4 needs to insert a buffer with a latency of $2d-1$ (assuming d >= 1) to match the arrival time of the partial result from superlane 0-3. The latency of the inserted buffer now has a dependency on the delay of the partial aggregation logic $d$. Therefore, for the balanced binary tree structure to fully cancel the impact of the partial aggregation logic delay, the number of superlanes advantageously should to be a power of 2.

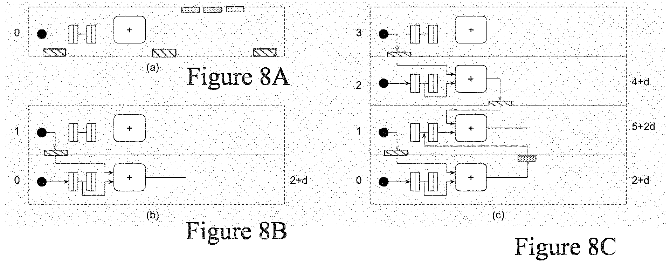

Figures 8A-8C illustrate a balanced binary tree comprising 4 superlanes. With the balanced binary tree structure, it is difficult to partition the entire aggregation tree into different superlanes while making the logic identical at each superlane. To address this issue, a unit design for each superlane and a connection scheme among different superlanes as depicted in Figures 8A-8C is used.

Figure 8A illustrates the unit design for the partial aggregation logic, which consists of an aggregation logic, a 4-entry delay buffer, 3 routing channels (depicted by the hatched rectangles) and 3 other routing channels (depicted by the dotted rectangles). The local input data is represented as a black circle.

Figure 8B illustrates how two adjacent superlanes (of a set of superlanes) should be connected. Assume input data at each superlane is staggered with 1 cycle delay. The local input from the higher superlane is routed to the lower superlane. Note that it is assumed that routing across the superlane boundary in the Y dimension adds one clock cycle latency. To match the input latency, the local input from the lower superlane needs to go through a 2-cycle buffer before feeding into the aggregation logic. The partial aggregation result is produced at time $2+d$. Note that the aggregation logic in the upper superlane remained unused. This connection scheme is applied to all pairs of adjacent 2 superlanes.

Figure 8C illustrates how to connect the partial aggregation results for 4 superlanes (e.g., a set of superlanes). The partial result (e.g., a first partial result of partial aggregation results) from the upper pair of superlanes (e.g., a first set of superlanes of a set of superlanes) is routed towards the partial result (e.g., a second partial result of the partial aggregation results) from the lower pair of superlanes (e.g., a second set of superlanes of the set of superlanes). The two partial results are aggregated at superlane 1, where the partial result from the lower pair is delayed by two cycles (e.g., a defined number of cycles, which might be more or less than two cycles) to match the latency for the input from the upper pair. The final partial result of 4 superlanes is produced at time *S+2d.* This connection scheme is applied to all pairs of adjacent 4 superlanes. Note that there is one unused aggregation logic block in superlane 3 in this scheme.

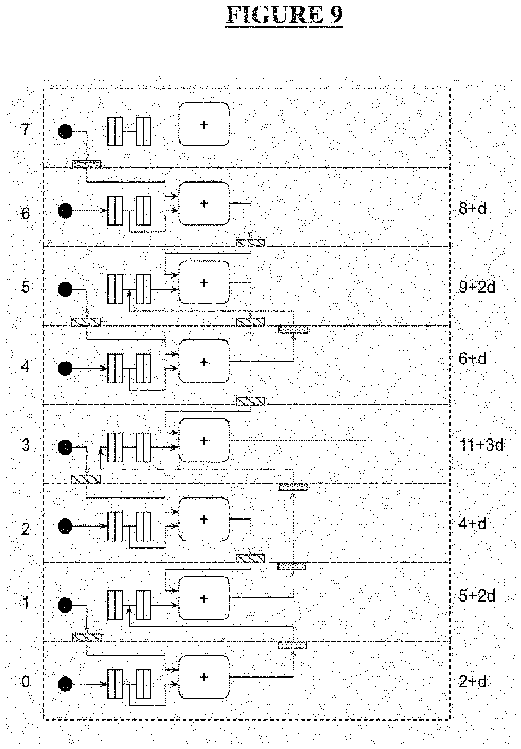

Figure 9 illustrates a balanced binary tree comprising 8 superlanes, which shows how to extend the connection scheme to go from 4 superlanes to 8. For 8-superlane connection, two 4-superlanes are stacked together, then the 4-superlane partial result is routed from superlane 5 to superlane 3. Similarly, the partial result from superlane 1 is routed to superlane 3. Now that the partial result from the upper 4-superlane is 4 clock cycles later than that from the lower 4-superlane, a 4-cycle delay buffer is inserted for the lower input in superlane 3.

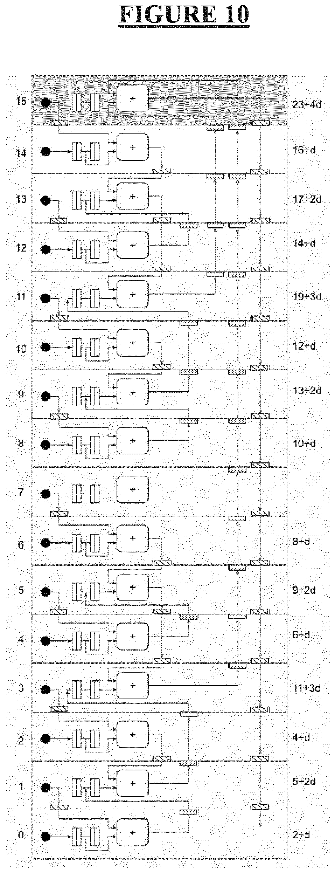

Figure 10 illustrates a balanced binary tree comprising 16 superlanes, which shows how to extend the connection scheme to go from 8 superlanes to 16. The 16-superlane connection can be completed by stacking two connected 8-superlanes, then routing the partial results to either superlane 7 or 15. If the total number of superlanes in the TSP is 16, then the partial results should be routed to superlane 15, so the final aggregation results can be distributed back to each superlane using a single bus, as is depicted in Figure 6. Note that no additional delay buffer is needed for the lower input operand of the partial aggregation logic at superlane 15. The delay is matched when the partial result from the lower 8-superlane meets the partial result from the upper-8 superlane.

Provided herein is a balanced binary tree structure for stream reducing operations. An embodiment relates to a method the includes incorporating a balanced binary tree structure into multiplication modules of a tensor processor to execute sequences of instructions more efficiently for Stream Reducing operations. In an implementation, the balanced binary tree structure can include at least four superlanes. However, in other implementations, the balanced binary tree structure can include any number of superlanes.

In some implementations, incorporating the balanced binary tree structure into multiplication modules of a tensor processor can include canceling a delay of a partial aggregation logic in the balanced binary tree structure. In some implementations, the incorporating can include canceling a delay dependency in aggregation logic. For example, canceling the delay dependency can include eliminating a requirement to stagger data streams according to an aggregation delay. In another example, the delay dependency can include unifying the Stream Reducing operations.

According to some implementations, incorporating the balanced binary tree structure can include enabling a compiler to locally optimize an aggregation operation. In some implementations, incorporating the balanced binary tree structure can include enabling the balanced binary tree structure with an identical unit logic design for a set of superlanes. Further to these implementations, for example, enabling the balanced binary tree structure can include operatively connecting two adjacent superlanes of the set of superlanes.

In another example, enabling the balanced binary tree structure can include operatively connecting partial aggregation results of the set of superlanes. Further to this example, the method can include routing a first partial result of the partial aggregation results for a first set of superlanes of the set of superlanes towards a second partial result of the partial aggregation results for a second set of superlanes of the set of superlanes. In some implementations, the method can include delaying the second partial result by a defined number of cycles determine to match a latency for the first partial result.

Another embodiment relates to a system that includes a compiler that incorporates a balanced binary tree into multiplication modules of a tensor processor to execute sequences of instructions more efficiently for Stream Reducing operations. In an example, the compiler adds a set of multiplexers at a position determined based on a location of a superlane. Further to this example, selection signals of the set of multiplexers can be controlled by a group of configuration registers.

In another example, the compiler can include a unit design for partial aggregation logic. Further to this example, the unit design for the partial aggregation logic can include a multiple-entry delay buffer, a first set of routing channels, and a second set of routing channels.

According to an implementation, the compiler enables the balanced binary tree that comprises an identical unit logic design for a set of superlanes. Further to this implementation, the compiler operatively connects two adjacent superlanes of the set of superlanes. In some implementations, the balanced binary tree can include at least four superlanes. However, in other implementations, the balanced binary tree can include fewer than four superlanes, four superlanes, or more than four superlanes.

## DETAILED DESCRIPTION - TECHNOLOGY SUPPORT

## FROM DATA/INSTRUCTIONS TO PROCESSORS/PROGRAMS

*Data and Information. While 'data' and 'information' often are used interchangeably (e.g., 'data processing' and 'information processing'), the term 'datum' (plural 'data') typically signifies a representation of the value of a fact (e.g., the measurement of a physical quantity such as the current in a wire, or the price of gold), or the answer to a question (e.g., "yes" or "no "), while the term 'information' typically signifies a set of data with structure (often signified by 'data structure'). A data structure is used in commerce to transform an electronic device for use as a specific machine as an article of*

manufacture (see In re Lowry, 32 F.3d 1579 [CAFC, 1994]). Data and information are physical objects, for example binary data (a 'bit,' usually signified with '0' and '1) enabled with two levels of voltage in a digital circuit or electronic component. For example, data can be enabled as an electrical, magnetic, optical, or acoustical signal or state; a quantum state such as a particle spin that enables a 'qubit; 'or a physical state of an atom or molecule. All such data and information, when enabled, are stored, accessed, transferred, combined, compared, or otherwise acted upon, actions that require and dissipate energy.

As used herein, the term 'Process' signifies an artificial finite ordered set of physical actions ('action' also signified by 'operation' or 'step') to produce at least one result. Some types of actions include transformation and transportation. An action is a technical application of one or more natural laws of science or artificial laws of technology. An action often changes the physical state of a machine, of structures of data and information, or of a composition of matter. Two or more actions can occur at about the same time, or one action can occur before or after another action, if the process produces the same result. A description of the physical actions and/or transformations that comprise a process are often signified with a set of gerund phrases (or their semantic equivalents) that are typically preceded with the signifier 'the steps of' (e.g., "a process comprising the steps of measuring, transforming, partitioning and then distributing... "). The signifiers 'algorithm,' 'method,' 'procedure,' '(sub) routine, ' 'Protocol,' 'recipe,' and 'technique ' often are used interchangeably with 'process, ' and 35 U.S.C. 100 defines a "method" as one type of process that is, by statutory law, always patentable under 35 U.S.C. 101. As used herein, the term 'thread' signifies a subset of an entire process. A process can be partitioned into multiple threads that can be used at or about at the same time.

As used herein, the term 'component' (also signified by 'part, ' and typically signified by 'element' when described in a patent text or diagram) signifies a physical object that is used to enable a process in combination with other components. For example, electronic components are used in processes that affect the physical state of one or more electromagnetic or quantum particles/waves (e.g., electrons, photons) or quasiparticles (e.g., electron holes, phonons, magnetic domains) and their associated fields or signals. Electronic components have at least two connection points which are attached to conductive components, typically a conductive wire or line, or an optical fiber, with one conductive component end attached to the component and the other end attached to another component, typically as part of a circuit with current or photon flows. There are at least three types of electrical components: passive, active and electromechanical. Passive electronic components typically do not introduce energy into a circuit - such components include resistors, memristors, capacitors, magnetic inductors, crystals, Josephson junctions, transducers, sensors, antennas, waveguides, etc. Active electronic components require a source of energy and can inject energy into a circuit - such components include semiconductors (e.g., diodes, transistors, optoelectronic devices), vacuum tubes, batteries, power supplies, displays (e.g., LEDs, LCDs, lamps, CRTs, plasma displays). Electromechanical components affect current flow using mechanical forces and structures - such components include switches, relays, protection devices (e.g., fuses, circuit breakers), heat sinks, fans, cables, wires, terminals, connectors, and printed circuit boards.

One of the most important components as goods in commerce is the integrated circuit, and its res of abstractions. As used herein, the term 'integrated circuit' signifies a set of connected electronic components on a small substrate (thus the use of the signifier 'chip') of semiconductor material, such as silicon or gallium arsenide, with components fabricated on one or more layers. Other signifiers for 'integrated circuit' include 'monolithic integrated circuit,' 'IC, ' 'chip, ' 'microchip' and 'System on Chip' ('SoC'). Examples of types of integrated circuits include gate/logic arrays, processors, memories, interface chips, power controllers, and operational amplifiers. The term 'cell' as used in electronic circuit design signifies a specification of one or more components, for example, a set of transistors that are connected to function as a logic gate. Cells are usually stored in a database, to be accessed by circuit designers and design processes.

As used herein, the term 'module' signifies a tangible structure for acting on data and information. For example, the term 'module' can signify a process that transforms data and information, for example, a process comprising a computer program (defined below). The term 'module ' also can signify one or more interconnected electronic components, such as digital logic devices. A process comprising a module, if specified in a programming language (defined below), such as System C or Verilog, also can be transformed into a specification for a structure of electronic components that transform data and information that produce the same result as the process. This last sentence follows from a modified Church-Turing thesis, which is simply expressed as "Whatever can be transformed by a (patentable) process and a processor, can be transformed by a (patentable) equivalent set of modules., " as opposed to the doublethink of deleting only one of the "(patentable)."

A module is permanently structured (e.g., circuits with unalterable connections), temporarily structured (e.g., circuits or processes that are alterable with sets of data), or a combination of the two forms of structuring. Permanently structured modules can be manufactured, for example, using Application Specific Integrated Circuits ('ASICs') such as Arithmetic Logic Units ('ALUs'), Programmable Logic Arrays ('PLAs'), or Read Only Memories ('ROMs'), all of which are typically structured during manufacturing. For example, a permanently structured module can comprise an integrated circuit.

*Temporarily structured modules can be manufactured, for example, using Field Programmable Gate Arrays (FPGAs - for example, sold by Xilinx or Intel's Altera), Random Access Memories (RAMs) or microprocessors. For example, data and information is transformed using data as an address in RAM or ROM memory that stores output data and information. One can embed temporarily structured modules in permanently structured modules (for example, a FPGA embedded into an ASIC).*

*Modules that are temporarily structured can be structured during multiple time periods. For example, a processor comprising one or more modules has its modules first structured by a manufacturer at a factory and then further structured by a user when used in commerce. The processor can comprise a set of one or more modules during a first time period, and then be restructured to comprise a different set of one or modules during a second time period. The decision to manufacture or implement a module in a permanently structured form, in a temporarily structured form, or in a combination of the two forms, depends on issues of commerce such as cost, time considerations, resource constraints, tariffs, maintenance needs, national intellectual property laws, and/or specific design goals [FACT]. How a module is used, its function, is mostly independent of the physical form in which it is manufactured or enabled. This last sentence also follows from the modified Church-Turing thesis.*

*As used herein, the term 'processor' signifies a tangible data and information processing machine for use in commerce that physically transforms, transfers, and/or transmits data and information, using at least one process. A processor consists of one or more modules, e.g., a central processing unit ('CPU') module; an input/output ('I/O') module, a memory control module, a network control module, and/or other modules. The term 'processor' can also signify one or more processors, or one or more processors with multiple computational coresICP Us, specialized processors (for example, graphics processors or signal processors), and their combinations. Where two or more processors interact, one or more of the processors can be remotely located relative to the position of the other processors. Where the term 'processor' is used in another context, such as a 'chemical processor,' it will be signified and defined in that context.*

*The processor can comprise, for example, digital logic circuitry (for example, a binary logic gate), and/or analog circuitry (for example, an operational amplifier). The processor also can use optical signal processing, DNA transformations, quantum operations, microfluidic logic processing, or a combination of technologies, such as an optoelectronic processor. For data and information structured with binary data, any processor that can transform data and information using the AND, OR and NOT logical operations (and their derivatives, such as the NAND, NOR, and XOR operations) also can transform data and information using any function of Boolean logic. A processor such as an analog processor,* *such as an artificial neural network, also can transform data and information. No scientific evidence exists that any of these technological processors are processing, storing and retrieving data and information, using any process or structure equivalent to the bioelectric structures and processes of the human brain.*

*The one or more processors also can use a process in a 'cloud computing' or 'timesharing' environment, where time and resources of multiple remote computers are shared by multiple users or processors communicating with the computers. For example, a group of processors can use at least one process available at a distributed or remote system, these processors using a communications network (e.g., the Internet, or an Ethernet) and using one or more specified network interfaces ('interface' defined below) (e.g., an application program interface ('API') that signifies functions and data structures to communicate with the remote process).*

*As used herein, the term 'computer' and 'computer system' (further defined below) includes at least one processor that, for example, performs operations on data and information such as (but not limited to) the Boolean logical operations using electronic gates that can comprise transistors, with the addition of memory (for example, memory structured with flip-flops using the NOT-AND or NOT-OR operation). Any processor that can perform the logical AND, OR and NOT operations (or their equivalent) is Turing-complete and computationally universal [FACT]. A computer can comprise a simple structure, for example, comprising an I/O module, a CPU module, and a memory that performs, for example, the process of inputting a signal, transforming the signal, and outputting the signal with no human intervention.*

*As used herein, the term Programming language' signifies a structured grammar for specifying sets of operations and data for use by modules, processors and computers. Programming languages include assembler instructions, instruction-set-architecture instructions, machine instructions, machine dependent instructions, microcode, firmware instructions, state-setting data, or either source code or object code written in any combination of one or more higher level languages, for example, the C programming language and similar general programming languages (such as Fortran, Basic, Javascript, PHP, Python, C++), knowledge programming languages (such as Lisp, Smalltalk, Prolog, or CycL), electronic structure programming languages (such as VHDL, Verilog, SPICE or SystemC), text programming languages (such as SGML, HTML, or XML), or audiovisual programming languages (such as SVG, MathML, X3D/VRML, or MIDI), and any future equivalent programming languages. As used herein, the term 'source code' signifies a set of instructions and data specified in text form using a programming language. A large amount of source code for use in enabling any of the claimed inventions is available on the Internet, such as from a source code library such as Github.*

*As used herein, the term program' (also re-*

ferred to as an 'application program') signifies one or more processes and data structures that structure a module, processor or computer to be used as a "specific machine" (see In re Alappat, 33 F3d 1526 [CAFC, 1991]). One use of a program is to structure one or more computers, for example, standalone, client or server computers, or one or more modules, or systems of one or more such computers or modules. As used herein, the term 'computer application' signifies a program that enables a specific use, for example, to enable text processing operations, or to encrypt a set of data. As used herein, the term firmware' signifies a type of program that typically structures a processor or a computer, where the firmware is smaller in size than a typical application program and is typically not very accessible to or modifiable by the user of a computer. Computer programs and firmware are often specified using source code written in a programming language, such as C. Modules, circuits, processors, programs, and computers can be specified at multiple levels of abstraction, for example, using the SystemC programming language, and have value as products in commerce as taxable goods under the Uniform Commercial Code (see U. C. C. Article 2, Part 1).

A program is transferred into one or more memories of the computer or computer system from a data and information device or storage system. A computer system typically has a device for reading storage media that is used to transfer the program, and/or has an interface device that receives the program over a network. This transfer is discussed in the General Computer Explanation section.

## DETAILED DESCRIPTION - TECHNOLOGY SUPPORT GENERAL COMPUTER EXPLANATION

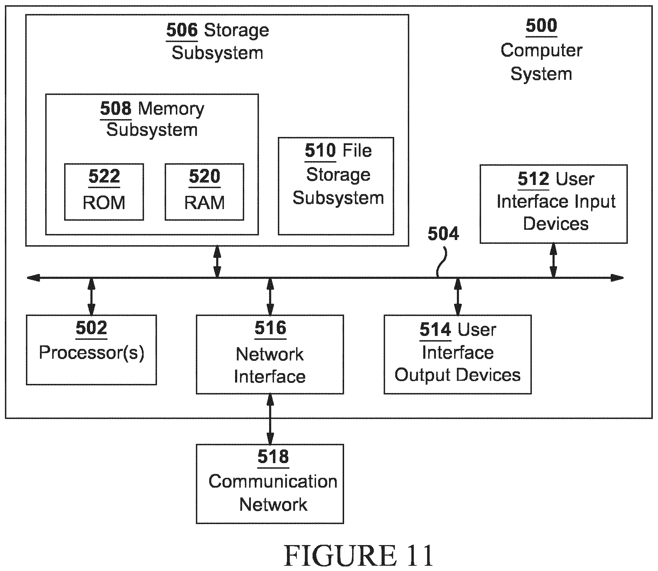

Figure 11 illustrates a computer system suitable for enabling embodiments of the claimed inventions.

In Figure 11, the structure of computer system 500 typically includes at least one computer which communicates with peripheral devices via bus subsystem 504. Typically, the computer includes a processor 502 (e.g., a microprocessor, graphics processing unit, or digital signal processor), or its electronic processing equivalents, such as an Application Specific Integrated Circuit ('ASIC') or Field Programmable Gate Array ('FPGA'). Typically, peripheral devices include a storage subsystem 506, comprising a memory subsystem 508 and a file storage subsystem 510, user interface input devices 512, user interface output devices 514, and/or a network interface subsystem 516. The input and output devices enable direct and remote user interaction with computer system 500. The computer system enables significant post-process activity using at least one output device and/or the network interface subsystem.

The computer system can be structured as a server, a client, a workstation, a mainframe, a personal computer (PC), a tablet PC, a set-top box (STB), a personal digital assistant (PDA), a cellular telephone, a smartphone, a web appliance, a rack-mounted 'blade', a kiosk, a television, a game station, a network router, switch or bridge, or any data processing machine with instructions that specify actions to be taken by that machine. The term 'server,' as used herein, refers to a computer or processor that typically performs processes for, and sends data and information to, another computer or processor.

A computer system typically is structured, in part, with at least one operating system program, such as Microsoft's Windows, Sun Microsystems's Solaris, Apple Computer's MacOs and iOS, Google 's Android, Linux and/or Unix. The computer system typically includes a Basic Input/Output System (BIOS) and processor firmware. The operating system, BIOS and firmware are used by the processor to structure and control any subsystems and interfaces connected to the processor. Typical processors that enable these operating systems include: the Pentium, Itanium, and Xeon processors from Intel; the Opteron and Athlon processors from Advanced Micro Devices; the Graviton processor from Amazon; the POWER processor from IBM; the SP ARC processor from Oracle; and the ARM processor from ARM Holdings.

Any ECIN is limited neither to an electronic digital logic computer structured with programs nor to an electronically programmable device. For example, the claimed inventions can use an optical computer, a quantum computer, an analog computer, or the like. Further, where only a single computer system or a single machine is signified, the use of a singular form of such terms also can signify any structure of computer systems or machines that individually or jointly use processes. Due to the ever-changing nature of computers and networks, the description of computer system 500 depicted in Figure 11 is intended only as an example. Many other structures of computer system 500 have more or less components than the computer system depicted in Figure 11.

Network interface subsystem 516 provides an interface to outside networks, including an interface to communication network 518, and is coupled via communication network 518 to corresponding interface devices in other computer systems or machines. Communication network 518 can comprise many interconnected computer systems, machines, and physical communication connections (signified by 'links'). These communication links can be wireline links, optical links, wireless links (e.g., using the WiFi or Bluetooth protocols), or any other physical devices for communication of information. Communication network 518 can be any suitable computer network, for example a wide area network such as the Internet, and/or a local-to-wide area network such as Ethernet. The communication network is wired and/or wireless, and many communication networks use encryption and decryption processes, such as is available with a virtual private network. The communication network uses one or more communications interfaces, which receive data from, and transmit data to, other systems. Embodiments of communications interfaces typically include an Ethernet card, a modem (e.g., telephone, satellite, cable, or ISDN), (asynchronous) digital subscriber line (DSL) unit, Firewire interface, USB interface, and the like. Communication algorithms ('protocols') can be specified using one or communication languages, such as HTTP, TCP/IP, RTP/RTSP, IPX and/or UDP.

User interface input devices 512 can include an alphanumeric keyboard, a keypad, pointing devices such as a mouse, trackball, toggle switch, touchpad, stylus, a graphics tablet, an optical scanner such as a bar code reader, touchscreen electronics for a display device, audio input devices such as voice recognition systems or microphones, eye-gaze recognition, brainwave pattern recognition, optical character recognition systems, and other types of input devices. Such devices are connected by wire or wirelessly to a computer system. Typically, the term 'input device' signifies all possible types of devices and processes to transfer data and information into computer system 500 or onto communication network 518. User interface input devices typically enable a user to select objects, icons, text and the like that appear on some types of user interface output devices, for example, a display subsystem.

User interface output devices 514 can include a display subsystem, a printer, a fax machine, or a non-visual communication device such as audio and haptic devices. The display subsystem can include a cathode ray tube (CRT), a flat-panel device such as a liquid crystal display (LCD), an image projection device, or some other device for creating visible stimuli such as a virtual reality system. The display subsystem also can provide non-visual stimuli such as via audio output, aroma generation, or tactile/haptic output (e.g., vibrations and forces) devices. Typically, the term 'output device' signifies all possible types of devices and processes to transfer data and information out of computer system 500 to the user or to another machine or computer system. Such devices are connected by wire or wirelessly to a computer system. Note: some devices transfer data and information both into and out of the computer, for example, haptic devices that generate vibrations and forces on the hand of a user while also incorporating sensors to measure the location and movement of the hand. Technical applications of the sciences of ergonomics and semiotics are used to improve the efficiency of user interactions with any processes and computers disclosed herein, such as any interactions with regards to the design and manufacture of circuits, that use any of the above input or output devices.

Memory subsystem 508 typically includes a number of memories including a main random-access memory ('RAM') 520 (or other volatile storage device) for storage of instructions and data during program execution and a read only memory ('ROM') 522 in which fixed instructions are stored. File storage subsystem 510 provides persistent storage for program and data files, and can include a hard disk drive, a floppy disk drive along with associated removable media, a CD-ROM drive, an optical drive, a flash memory such as a USB drive, or removable media cartridges. If computer system 500 includes an input device that performs optical character recognition, then text and symbols printed on paper can be used as a device for storage of program and data files. The databases and modules used by some embodiments can be stored by file storage subsystem 510.

Bus subsystem 504 provides a device for transmitting data and information between the various components and subsystems of computer system 500. Although bus subsystem 504 is depicted as a single bus, alternative embodiments of the bus subsystem can use multiple busses. For example, a main memory using RAM can communicate directly with file storage systems using Direct Memory Access ('DMA') systems.

## DETAILED DESCRIPTION - SEMANTIC SUPPORT

The signifier 'commercial solution' signifies, solely for the following paragraph, a technology domain-specific (and thus non-preemptive - see Bilski): electronic structure, process for a specified machine, manufacturable circuit (and its Church-Turing equivalents), or composition of matter that applies science and/or technology for use in commerce to solve an unmet need of technology.

The signifier 'abstract' (when used in a patent claim for any enabled embodiments disclosed herein for a new commercial solution that is a scientific use of one or more laws of nature {see Benson}, and that solves a problem of technology {see Diehr} for use in commerce - or improves upon an existing solution used in commerce {see Diehr}) - is precisely defined by the inventor(s) {see MPEP 2111.01 (9th edition, Rev. 08.2017)} as follows:

a) a new commercial solution is 'abstract' if it is not novel (e.g., it is so well known in equal prior art {see Alice} and/or the use of equivalent prior art solutions is long prevalent {see Bilski} in science, engineering or commerce), and thus unpatentable under 35 U.S.C. 102, for example, because it is 'difficult to understand' {see Merriam-Webster definition for 'abstract'} how the commercial solution differs from equivalent prior art solutions; or

b) a new commercial solution is 'abstract' if the existing prior art includes at least one analogous prior art solution {see KSR}, or the existing prior art includes at least two prior art publications that can be combined {see Alice} by a skilled person {often referred to as a 'PHOSITA', see MPEP 2141-2144 (9th edition, Rev. 08.2017)} to be equivalent to the new commercial solution, and is thus unpatentable under 35 U.S.C. 103, for example, because it is 'difficult to understand' how the new commercial solution differs from a PHOSITA-combination/-application of the existing prior art; or

c) a new commercial solution is 'abstract' if it is not

*disclosed with a description that enables its praxis, either because insufficient guidance exists in the description, or because only a generic implementation is described {see Mayo} with unspecified components, parameters or functionality, so that a PHOSITA is unable to instantiate an embodiment of the new solution for use in commerce, without, for example, requiring special programming {see Katz} (or, e.g., circuit design) to be performed by the PHOSITA, and is thus unpatentable under 35 U.S.C. 112, for example, because it is 'difficult to understand' how to use in commerce any embodiment of the new commercial solution.*

### DETAILED DESCRIPTION - CONCLUSION

*The Detailed Description signifies in isolation the individual features, structures, functions, or characteristics described herein and any combination of two or more such features, structures, functions or characteristics, to the extent that such features, structures, functions or characteristics or combinations thereof are enabled by the Detailed Description as a whole in light of the knowledge and understanding of a skilled person, irrespective of whether such features, structures, functions or characteristics, or combinations thereof, solve any problems disclosed herein, and without limitation to the scope of the Claims of the patent. When an ECIN comprises a particular feature, structure, function, or characteristic, it is within the knowledge and understanding of a skilled person to use such feature, structure, function, or characteristic in connection with another ECIN whether or not explicitly described, for example, as a substitute for another feature, structure, function, or characteristic.*

*In view of the Detailed Description, a skilled person will understand that many variations of any ECIN can be enabled, such as function and structure of elements, described herein while being as useful as the ECIN. One or more elements of an ECIN can be substituted for one or more elements in another ECIN, as will be understood by a skilled person. Writings about any ECIN signify its use in commerce, thereby enabling other skilled people to similarly use this ECIN in commerce.*

*This Detailed Description is fitly written to provide knowledge and understanding. It is neither exhaustive nor limiting of the precise structures described but is to be accorded the widest scope consistent with the disclosed principles and features. Without limitation, any and all equivalents described, signified or Incorporated By Reference (or explicitly incorporated) in this patent application are specifically incorporated into the Detailed Description. In addition, any and all variations described, signified, or incorporated with respect to any one ECIN also can be included with any other ECIN. Any such variations include both currently known variations as well as future variations, for example any element used for enablement includes a future equivalent element that provides the same function, regardless of the structure of the future equivalent element.*

### Claims

1. A method, comprising:
   incorporating a balanced binary tree structure into multiplication modules of a tensor processor to execute sequences of instructions more efficiently for Stream Reducing operations.

2. The method of claim 1, wherein the incorporating comprises canceling a delay of a partial aggregation logic in the balanced binary tree structure, or wherein the incorporating comprises canceling a delay dependency in aggregation logic.

3. The method of claim 2, wherein the canceling the delay dependency comprises eliminating a requirement to stagger data streams according to an aggregation delay, or wherein the canceling the delay dependency comprises unifying the Stream Reducing operations.

4. The method of claim 1, wherein the incorporating the balanced binary tree structure comprises enabling a compiler to locally optimize an aggregation operation, or wherein the incorporating the balanced binary tree structure comprise enabling the balanced binary tree structure with an identical unit logic design for a set of superlanes.

5. The method of claim 4, wherein the enabling the balanced binary tree structure comprises operatively connecting two adjacent superlanes of the set of superlanes, or wherein the enabling the balanced binary tree structure comprises operatively connecting partial aggregation results of the set of superlanes.

6. The method of claim 5, further comprising:
   routing a first partial result of the partial aggregation results for a first set of superlanes of the set of superlanes towards a second partial result of the partial aggregation results for a second set of superlanes of the set of superlanes.

7. The method of claim 6, further comprising:
   delaying the second partial result by a defined number of cycles determine to match a latency for the first partial result.

8. The method of claim 1, wherein the balanced binary tree structure comprises at least four superlanes.

9. A system, comprising:
   a compiler that incorporates a balanced binary tree into multiplication modules of a tensor processor to execute sequences of instructions more efficiently for Stream Reducing operations.

10. The system of claim 9, wherein the compiler adds a set of multiplexers at a position determined based on a location of a superlane.

11. The system of claim 10, wherein selection signals of the set of multiplexers are controlled by a group of configuration registers.

12. The system of claim 9, wherein the compiler comprises a unit design for partial aggregation logic, or wherein the compiler enables the balanced binary tree that comprises an identical unit logic design for a set of superlanes.

13. The system of claim 12, wherein the unit design for the partial aggregation logic comprises a multiple-entry delay buffer, a first set of routing channels, and a second set of routing channels.

14. The system of claim 12, wherein the compiler operatively connects two adjacent superlanes of the set of superlanes.

15. The system of claim 9, wherein the balanced binary tree comprises at least four superlanes.

# FIGURE 1

100

User Device 102

API
104

Visualizer UI

Compiler
112

Compiled
Programs
114

Visualizer

Visualization Server

Assembler
116

Compiler/Assembler
Server 110

TSP 120

# FIGURE 2A

# FIGURE 2B

# FIGURE 3

# FIGURE 4

# FIGURE 5

# FIGURE 6

# FIGURE 7

(a)

Figure 8A

(b)

Figure 8B

(c)

Figure 8C

# FIGURE 9

# FIGURE 10

**506** Storage Subsystem

**500** Computer System

**508** Memory Subsystem

**510** File Storage Subsystem

**522** ROM

**520** RAM

**512** User Interface Input Devices

**504**

**502** Processor(s)

**516** Network Interface

**514** User Interface Output Devices

**518** Communication Network

FIGURE 11

Europäisches
Patentamt

European
Patent Office

Office européen
des brevets

# EUROPEAN SEARCH REPORT

Application Number

EP 24 20 1652

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | ABTS DENNIS ET AL: "Think fast a tensor streaming processor (TSP) for accelerating deep learning workloads", PROCEEDINGS OF THE ACM/SPEC INTERNATIONAL CONFERENCE ON PERFORMANCE ENGINEERING, ACMPUB27, NEW YORK, NY, USA, 30 May 2020 (2020-05-30), pages 145-158, XP058563235, DOI: 10.1109/ISCA45697.2020.00023 ISBN: 978-1-4503-8198-7 * abstract * * page 146, left-hand column, paragraph 1 - page 149, right-hand column, paragraph 1; figures 1,2 * * page 150, left-hand column, last paragraph - page 150, right-hand column, paragraph 1 * * page 150, right-hand column, last paragraph - page 153, right-hand column, paragraph 2 * ----- | 1-15 | INV. G06F15/80 G06F30/30 G06F9/30 |
| Y | US 2022/129320 A1 (MOHAPATRA DEBABRATA [US] ET AL) 28 April 2022 (2022-04-28) * abstract; figures 3,5 * * page 1, paragraph 3 - page 3, paragraph 18 * * page 4, paragraph 29 - page 6, paragraph 43 * * page 7, paragraph 46 - page 7, paragraph 48 * ----- | 1-15 | **TECHNICAL FIELDS SEARCHED (IPC)** G06F |

The present search report has been drawn up for all claims

| Place of search | Date of completion of the search | Examiner |
|---|---|---|
| Munich | 21 January 2025 | Lelait, Sylvain |

EPO FORM 1503 03.82 (P04C01)

**ANNEX TO THE EUROPEAN SEARCH REPORT
ON EUROPEAN PATENT APPLICATION NO.**

EP 24 20 1652

This annex lists the patent family members relating to the patent documents cited in the above-mentioned European search report.
The members are as contained in the European Patent Office EDP file on
The European Patent Office is in no way liable for these particulars which are merely given for the purpose of information.

21-01-2025

| Patent document cited in search report | Publication date | Patent family member(s) | | Publication date |
|---|---|---|---|---|
| US 2022129320 A1 | 28-04-2022 | CN | 117642721 A | 01-03-2024 |
| | | EP | 4427132 A1 | 11-09-2024 |
| | | US | 2022129320 A1 | 28-04-2022 |
| | | WO | 2023080976 A1 | 11-05-2023 |

EPO FORM P0459

For more details about this annex : see Official Journal of the European Patent Office, No. 12/82

## EP 4 528 525 A1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63584353